(19) Europäisches Patentamt
European Patent Office
Office européen des brevets

(11) Veröffentlichungsnummer : **0 502 819 A1**

# (12) EUROPÄISCHE PATENTANMELDUNG

(21) Anmeldenummer : **92810125.2**

(22) Anmeldetag : **20.02.92**

(51) Int. Cl.[5] : **C08F 212/14,** G03F 7/038

(30) Priorität : **01.03.91 CH 624/91**

(43) Veröffentlichungstag der Anmeldung : **09.09.92 Patentblatt 92/37**

(84) Benannte Vertragsstaaten : **AT BE CH DE ES FR GB IT LI NL SE**

(71) Anmelder : **CIBA-GEIGY AG**
**Klybeckstrasse 141**
**CH-4002 Basel (CH)**

(72) Erfinder : **Schädeli, Ulrich, Dr.**
**Im Hubel**
**CH-1737 Plasselb (CH)**

## (54) Säurekatalytisch vernetzbare Copolymere.

(57) Es werden säurekatalytisch vernetzbare Copolymere mit einem Molekulargewicht (Mw) von $10^3$ bis $10^6$, gemessen mittels Gelpermeationschromatographie, beschrieben, die aus

a) 100-80 Mol.% wiederkehrender Strukturelemente der Formeln I und II

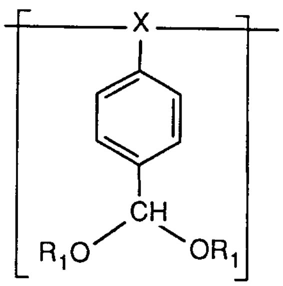

und

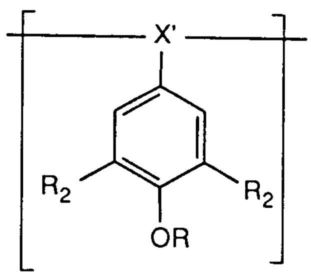

(I) (II)

im Verhältnis von 1 :1 bis 1 :9 und

b) 0-20 Mol. % wiederkehrender Strukturelemente der Formel III

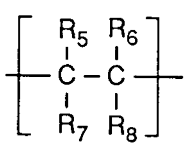

(III)

bestehen, worin

X und X′ unabhängig voneinander

$-CH-CH_2-$, $-C(CH_3)-CH_2-$ oder

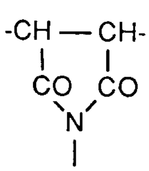

bedeuten,

R Wasserstoff oder eine unter Säureeinwirkung abspaltbare Schutzgruppe ist, die $R_1$ unabhängig voneinander $C_1$-$C_5$-Alkyl, Phenyl oder Naphthyl bedeuten oder zusammen 1,2-Phenylen oder $-[C(R_3)(R_4)]_x-$ mit $R_3$ und/oder $R_4$ = Wasserstoff oder Methyl und x = 2 bis 5 darstellen, die $R_2$ unabhängig voneinander Wasserstoff, $C_1$-$C_5$-Alkyl oder $C_1$-$C_5$-Alkoxy darstellen,

$R_5$ und $R_7$ je Wasserstoff sind,

$R_6$ Wasserstoff, Halogen oder Methyl und

EP 0 502 819 A1

$R_8$ Wasserstoff, Halogen, Methyl, $-CH_2$Halogen, $-CH_2CN$, -CN, -COOH, $-CONH_2$, -O-$C_1$-$C_5$-Alkyl, -O-CO-$C_1$-$C_5$-Alkyl, -COO-$C_1$-$C_5$-Alkyl, -COO-Phenyl oder Phenyl bedeuten,
oder $R_5$ und $R_5$ je Wasserstoff sind und $R_7$ und $R_5$ zusammen -CO-O-CO- oder unabhängig voneinander -COOH oder -COO-$C_1$-$C_5$-Alkyl, darstellen.

Die genannten Copolymeren eignen sich zusammen mit Verbindungen, die unter aktinischer Strahlung Säure bilden, zur Herstellung von Negativresist-Systemen.

Die vorliegende Erfindung betrifft säurekatalytisch vernetzbare Copolymere aus acetalisierten und OH-gruppenhaltigen Vinylbenzolen oder N-Phenylmaleinimiden, solche copolymere und eine säurebildende Substanz enthaltende strahlungsempfindliche Zusammensetzungen und deren Verwendung als Negativresist zur Herstellung von Schutzschichten und Reliefstrukturen.

Aus der Literatur sind nach dem Prinzip der sog. chemischen Amplifikation arbeitende Negativresist-Zusammensetzungen bekannt. So beschreiben J.M.F. Fréchet et al. in Polym. Mat. Sci. Eng., 60 (1989) 147-150, in Macromolecules, 24 (1991) 1746-1754 oder in Polymer Engineering and Science, 29 Nr. 14 (July 1989) 960-964 Negativresists des Amplifikationstyps basierend auf elektrophiler aromatischer Substitution. Dabei werden aus 4-t-Butyloxycarbonylstyrol und 4-Acetyloxymethylstyrol Copolymere hergestellt und diese nach Abspaltung der t.Butyloxycarbonyl-Schutzgruppen in Gegenwart eines Triarylsulfoniumsalzes als Säuregenerator, wie Triphenylsulfonium-hexafluorantimonat, mit UV-Licht bei 254 nm bestrahlt, wobei die bestrahlten Stellen vernetzt werden. Anstelle der genannten Gemische aus Copolymer und säuregenerierendem Triarylsulfoniumsalz können auch 3-Komponentensysteme aus mehrfunktionellen niedermolekularen latenten Elektrophilen, wie 1,4-Bis(acetyloxymethyl)benzol, Triarylsulfoniumsalz und einem phenolischen Polymer verwendet werden. Aehnliche Negativresist-Systeme auf der Basis von Oniumsalzen, einer polyfunktionellen Verbindung mit aktivierten aromatischen Ringen und einer Carboniumionen liefernden polyfunktionellen Verbindung, wobei mindestens eine dieser beiden Verbindungen ein Polymer oder Copolymer ist, sind in der US-A 4,800,152 beschrieben. M Hatzakis et al. beschreiben in Microelectronic Engineering, 11 ( 1990) 487-490 Negativresist-Zusammensetzungen auf der Basis von epoxidierten Novolaken und Oniumsalzen als säuregenerierende Substanzen. Diese letzteren Systeme sind nicht wässrig-alkalisch entwickelbar.

Andererseits ist bekannt, dass sich durch Säure spaltbare monomere oder polymere Acetale und Ketale zusammen mit photoaktivierbaren säurebildenden Verbindungen und gegebenenfalls Bindemitteln zur Herstellung von positiv arbeitenden Photoresistsystemen eignen (s. z.B. DE-A 2718 254, US-A 3,779,778 und EP-A 0 202196).

Es wurde nun gefunden, dass sich bestimmte Copolymere aus acetalisierten und OH-gruppenhaltigen Vinylbenzolen oder N-Phenylmaleinimiden überraschenderweise zur Herstellung von nach dem Prinzip der chemischen Amplifikation arbeitenden Negativresistsystemen eignen.

Gegenstand der Erfindung sind daher säurekatalytisch vernetzbare Copolymere mit einem Molekulargewicht (Mw) von $10^3$ bis $10^6$, gemessen mittels Gelpermeationschromatographie, die aus

a) 100-80 Mol.%o wiederkehrender Strukturelemente der Formeln I und II

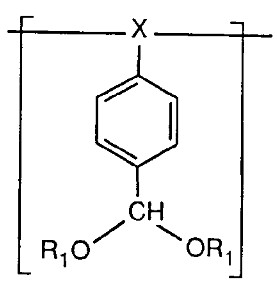

(I)

und

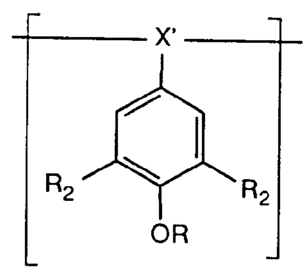

(II)

im Verhältnis von 1:1 bis 1:9, bevorzugt 1:2 bis 1:4, und

b) 0-20 Mol.% wiederkehrender Strukturelemente der Formel III

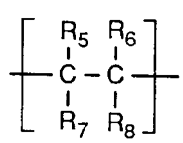

(III)

bestehen, worin

X und X′ unabhängig voneinander

$-CH-CH_2-$, $-C(CH_3)-CH_2-$ oder 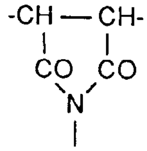

bedeuten,
R Wasserstoff oder eine unter Säureeinwirkung abspaltbare Schutzgruppe ist, die $R_1$ unabhängig voneinander $C_1$-$C_5$-Alkyl, Phenyl oder Naphthyl bedeuten oder zusammen 1,2-Phenylen oder $-[C(R_3)(R_4)]_x-$ mit $R_3$ und/oder $R_4$ = Wasserstoff oder Methyl und x = 2 bis 5, besonders 2 bis 4, darstellen,
die $R_2$ unabhängig voneinander Wasserstoff, $C_1$-$C_5$-Alkyl oder $C_1$-$C_5$-Alkoxy darstellen,
$R_5$ und $R_7$ je Wasserstoff sind,
$R_6$ Wasserstoff, Halogen oder Methyl und
$R_8$ Wasserstoff, Halogen, Methyl, $-CH_2$Halogen, -CN, $-CH_2CN$, -COOH, $-CONH_2$, -O-$C_1$-$C_5$-Alkyl, -O-CO-$C_1$-$C_5$-Alkyl, -COO-$C_1$-$C_5$-Alkyl, -COO-Phenyl oder Phenyl bedeuten,
oder $R_5$ und $R_6$ je Wasserstoff sind und $R_7$ und $R_8$ zusammen -CO-O-CO- oder unabhängig voneinander -COOH oder -COO-$C_1$-$C_5$-Alkyl darstellen.

Die erfindungsgemässen Copolymeren weisen bevorzugt ein Molekulargewicht (Mw) von 5'000 bis 500'000, insbesondere 5'000 bis 20'000, auf.

Des weiteren sind Copolymere bevorzugt, worin der Anteil an wiederkehrenden Strukturelementen der Formeln I und II 100 bis 90 Mol.% und derjenige an Strukturelementen der Formel III 0-10 Mol. % beträgt.

X und X' stellen bevorzugt

$$-C(CH_3)-CH_2-$$

und insbesondere je

$$-CH-CH_2-$$

dar.

Als Beispiele für unter Säureeinwirkung abspaltbare Schutzgruppen R seien Reste der Formeln IV-VII

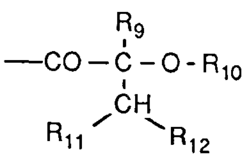 (IV), 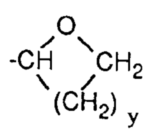 (V), $-COO-C(CH_3)_3$ (VI) und

$-CO-R_{13}$ (VII) genannt, worin
$R_9$ Wasserstoff oder Methyl ist,
$R_{10}$ $C_1$-$C_5$-Alkyl, Phenyl oder Naphthyl bedeutet und $R_{11}$ und $R_{12}$ unabhängig voneinander Wasserstoff, $C_1$-$C_5$-Alkyl, Phenyl oder Naphthyl sind, oder
$R_{10}$ und $R_{12}$ zusammen unsubstituiertes oder durch $C_1$-$C_4$-Alkyl, $C_1$-$C_4$-Alkoxy, Phenyl, Naphthyl, Phenoxy oder Naphthyloxy substituiertes Ethylen, Propylen oder Butylen darstellen,
y für 2, 3 oder 4 steht, und
$R_{13}$ $C_1$-$C_5$-Alkyl oder $C_1$-$C_5$-Alkoxy bedeutet.

Durch $R_1$, $R_2$, $R_{10}$, $R_{11}$, $R_{12}$ oder $R_{13}$ dargestellte oder in Resten $R_6$, $R_{10}$ und $R_{12}$ enthaltene Alkylgruppen sowie Alkoxygruppen $R_2$ und $R_{13}$ oder in Resten $R_{10}$ oder $R_{12}$ enthaltene Alkoxygruppen können geradkettig oder verzweigt sein. Als Beispiele seien genannt: Methyl, Ethyl, n-Propyl, Isopropyl, n-, sec- und tert.Butyl, n-Pentyl, Methoxy, Ethoxy, n-Propoxy, Isopropyloxy, n- und tert.Butyloxy, n-Pentyloxy.

$R_1$, $R_2$, $R_{10}$, $R_{11}$ und $R_{12}$ als Alkyl bzw. Alkoxy sind insbesondere Methyl, Ethyl, Methoxy oder Ethoxy, vor allem Methyl oder Methoxy. Halogen in Gruppen $R_6$ und Rg ist z.B. Cl, Br oder F.

Die beiden $R_1$ bedeuten bevorzugt $-[C(R_3)(R_4)]_x-$ mit $x = 2$ bis 4, insbesondere 2 oder 3. Die $R_2$ sind bevorzugt Wasserstoff.

In bevorzugten Resten der Formel IV hat $R_9$ die angegebene Bedeutung, $R_{10}$ ist Methyl oder Ethyl, $R_{11}$ und $R_{12}$ stellen unabhängig voneinander Wasserstoff oder Methyl dar oder $R_{10}$ und $R_{12}$ bedeuten zusammen unsubstituiertes Ethylen oder Propylen. y in Resten der Formel V ist vorzugsweise 2 oder 3, und in Resten der Formel VII stellt $R_{13}$ insbesondere $C_1$-$C_5$-Alkoxy, vor allem tert.Butyloxy, dar.

R ist bevorzugt Wasserstoff oder $-COO-C(CH_3)_3$ und vor allem ein Rest der Formel V mit $y = 2$ und insbesondere 3. Ganz besonders bevorzugt ist R Wasserstoff.

Die erfindungsgemässen Copolymeren können auf an sich bekannte Weise durch radikalische Copolymerisation von 100-80 Mol.% Verbindungen der Formel Ia und IIa

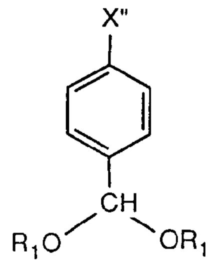 (Ia) und 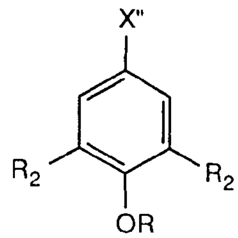 (IIa)

im Verhältnis von 1:1 bis 1:9 und
0-20 Mol.% einer Verbindung der Formel IIIa.

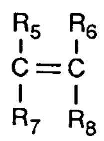 (IIIa),

worin R, $R_1$, $R_2$ und $R_5$ bis $R_8$ die oben angegebene Bedeutung haben und X″

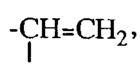,

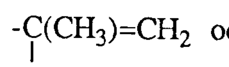 oder 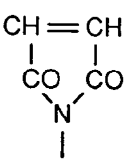

bedeutet, und gegebenenfalls säurekatalysiertes Abspalten der Schutzgruppe R, hergestellt werden.

Oft ist es von Vorteil, für die Copolymerisation Verbindungen der Formel IIa, worin R eine unter Säureeinwirkung abspaltbare Schutzgruppe ist, zu verwenden. Es ist auch nicht erforderlich, die Schutzgruppe R vor dem Einsatz der erfindungsgemässen Copolymeren in Negativresist-Systemen zu entfernen. Bevorzugt erfolgt diese Entfernung in Gegenwart einer unter aktinischer Strahlung säurebildenden Verbindung.

Die radikalische Copolymerisation kann unter Anwendung verschiedener Techniken durchgeführt werden. Diese sind beispielsweise von S. Sandler und W. Karo in "Polymer Synthesis", Bd. 1-3, 1968, Academic Press, New York, beschrieben worden. Uebliche Polymerisationsverfahren sind beispielsweise die Polymerisation in der Masse oder in Lösungsmitteln, Emulsions-, Suspension- oder Fällungspolymerisation.

Die Ausgangsprodukte der Formel Ia sind bekannt oder können nach an sich bekannten Methoden hergestellt werden, z.B. durch Umsetzung der entsprechenden Benzaldehyde mit Brenzkatechin, Mono- oder Dihydroxyverbindungen $R_1OH$ oder $HO-[C(R_3)(R_4)]_x-OH$.

Die Verbindungen der Formel IIa mit R = H sind grösstenteils bekannt oder können nach an sich bekannten Verfahren hergestellt werden. Verbindungen der Formel IIa, worin R eine definitionsgemäss Schutzgruppe darstellt, können durch Umsetzung der entsprechenden Verbindungen der Formel IIa mit R = H mit Verbindungen der Formeln IVa bis VIIa

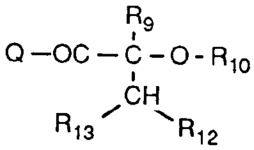 (IVa), 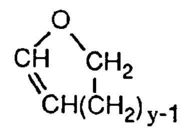 (Va), 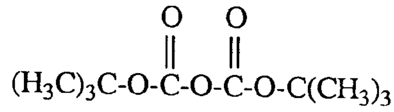 (VIa)

und $Q-CO-R_{13}$ (VIIa),
worin Q eine reaktionsfähige Gruppe, z.B. -Cl, darstellt, erhalten werden.

Die Verbindungen der Formel IIIa sind ebenfalls bekannt und zum Teil im Handel erhältlich. Beispiele von Monomeren der Formel IIIa sind Ethylen, Propylen, Styrol, α-Methylstyrol, Acrylnitril, α,β-ungesättigte Säuren und Amide, wie z.B. Acrylsäure, Acrylsäuremethylester und Acrylsäureamid und die entsprechenden Methacrylverbindungen, Maleinsäure, Maleinsäuremethylester, Maleinsäuredimethyl- und -diethylester, halogenhaltige Vinylverbindungen, wie z.B. Vinylchlorid, Vinylfluorid, Vinylidenchlorid oder Vinylidenfluorid, Vinylester und Vinylether, wie z.B. Vinylacetat, Methylvinylether und Butylvinylether. Weitere geeignete Verbindungen sind z.B. Allylbromid, Allylchlorid und Allylcyanid.

Die Polymerisation wird in der Regel durch einen der üblichen Initiatoren der radikalischen Polymerisation eingeleitet. Dazu zählen thermische Initiatoren, wie Azoverbindungen, beispielsweise α,α'-Azoisobutyronitril (AIBN), oder Peroxide, beispielsweise Benzoylperoxid, oder Redoxinitiatorsysteme, wie eine Mischung von Eisen(III)acetyl-acetonat, Benzoin und Benzoylperoxid, oder photochemische Radikalbildner, wie Benzoin oder Benzildimethylketal.

Die Polymerisation wird bevorzugt in Lösung durchgeführt. Die Reaktionstemperatur bewegt sich im allgemeinen im Bereich von 10 bis 200°C, vorzugsweise zwischen 40 und 150°C, besonders bevorzugt zwischen 40 und 100°C.

Gegebenenfalls anwesende Lösungsmittel müssen unter den Reaktionsbedingungen inert sein. Als Lösungsmittel kommen u.a. aromatische Kohlenwasserstoffe, chlorierte Kohlenwasserstoffe, Ketone und Ether in Betracht. Beispiele hierfür sind: Benzol, Toluol, Xylole, Ethylbenzol, Isopropylbenzol, Ethylenchlorid, Propylenchlorid, Methylenchlorid, Chloroform, Methylethylketon, Aceton, Cyclohexanon, Diethylether oder Tetrahydrofuran.

Die erfindungsgemässen Copolymeren eignen sich zur Herstellung von hoch empfindlichen wässrig-alkalisch entwickelbaren Negativresist-Zusammensetzungen.

Gegenstand der Erfindung sind daher auch strahlungsempfindliche Zusammensetzungen enthaltend
i) mindestens ein definitionsgemässes Copolymer und
ii) mindestens eine unter aktinischer Strahlung säurebildende Verbindung.

Dabei katalysiert die in den bestrahlten Bereichen gebildete Säure, unter Abspaltung allfällig vorhandener Schutzgruppen R, die Vernetzung des Copolymeren. Bevorzugte Copolymere i) sind im Vorangehenden erläutert.

Als unter aktinischer Strahlung säurebildende Verbindungen kommen z.B. in Betracht:

Als Verbindungen ii), die unter aktinischer Strahlung Säure bilden, kommen insbesondere Oniumsalze, wie Diazonium-, Sulfonium-, Sulfoxonium- und Iodoniumsalze in Betracht. Bevorzugt sind Sulfoniumsalze der Formel VIII

$$(Ar_1)_q(Z_1)_r(Z_2)_sS^{\oplus}X_1^{\ominus} \quad \text{(VIII)},$$

worin
$Ar_1$ unsubstituiertes oder durch Halogen, $C_1$-$C_4$-Alkyl, $C_1$-$C_4$-Alkoxy, -OH und/oder Nitro substituiertes Phenyl, Naphthyl oder Phenyl-$COCH_2$- ist,
$Z_1$ $C_1$-$C_6$-Alkyl oder $C_3$-$C_7$-Cycloalkyl und
$Z_2$ Tetrahydrothienyl, Tetrahydrofuryl oder Hexahydropyryl sind,
q für 0, 1, 2 oder 3,
r für 0, 1 oder 2 und
s für 0 oder 1 stehen, wobei die Summe q+r+s 3 beträgt, und
$X_1^{\ominus}$ ein Chlorid-, Bromid- oder Iodidanion, $BFq^{\ominus}$, $PF_6^{\ominus}$, $AsF_6^{\ominus}$, $SbF_6^{\ominus}$, $FSO^{\ominus}$ oder das Anion einer organischen Sulfonsäure oder Carbonsäure ist.

Phenyl-, Naphthyl- und Phenacylgruppen $Ar_1$ sind bevorzugt einfach substituiert, insbesondere durch Cl, Br, Methyl, Methoxy, -OH oder Nitro. Besonders bevorzugt sind diese Reste unsubstituiert. $Z_1$ ist vorzugsweise $C_1$-$C_4$-Alkyl, insbesondere Methyl oder Ethyl. Bevorzugt sind q 2 oder 3, r 1 oder Null und s Null, insbesondere ist q = 3 und r und s sind Null. Ganz besonders bevorzugt ist $Ar_1$ unsubstituiertes Phenyl und q ist 3.

Stellt $X_1^{\ominus}$ das Anion einer organischen Sulfonsäure oder Carbonsäure dar, so kann es sich um Anionen von aliphatischen, cycloaliphatischen, carbocyclisch-aromatischen, heterocyclisch-aromatischen oder araliphatischen Sulfon- oder Carbonsäuren handeln. Diese Anionen können substituiert oder unsubstituiert sein. Bevorzugt sind Sulfon- und Carbonsäure mit geringer Nucleophilie, beispielsweise teil- oder perfluorierte Derivate oder in Nachbarstellung zur jeweiligen Säuregruppe substituierte Derivate. Beispiele für Substituenten sind Halogen, wie Chlor oder besonder Fluor, Alkyl, wie Methyl, Ethyl oder n-Propyl, oder Alkoxy, wie Methoxy, Ethoxy oder n-Propoxy.

Beispiele für aliphatische Sulfonsäuren sind Methan-, Ethan-, n-Propan-, n-Butan- und n-Hexansulfonsäure oder die entsprechenden teil- oder perfluorierten Derivate.

Beispiele für aliphatische Carbonsäuren sind Ameisensäure, Essigsäure, Propionsäure, Buttersäure, Pivalinsäure, Capronsäure, 2-Ethylhexylcarbonsäure und Fettsäuren, wie Laurinsäure, Myristinsäure oder Stearinsäure, sowie die teil- oder perfluorierten Derivate dieser Säuren.

Beispiele für cycloaliphatische Sulfon- oder Carbonsäuren sind Cyclohexansulfonsäure, Cyclohexancarbonsäure, Campher- 10-sulfonsäure oder deren teil- oder perfluorierte Derivate.

Beispiele für carbocyclisch-aromatische Sulfonsäuren sind Benzol-, Toluol-, Ethylbenzol-, Isopropylbenzol-, Dodecylbenzol- oder Dimethylbenzolsulfonsäure, 2,4,6-Triisopropylbenzolsulfonsäure, 2,4,6-Trimethylbenzolsulfonsäure, Naphthalin-mono-, -di- oder -tri-sulfonsäuren und die entsprechenden alkylierten oder teil- oder perfluorierten Derivate dieser Sulfonsäuren.

Beispiele für heterocyclisch-aromatische Sulfonsäuren sind Pyridin-, Thiophen- oder Pyrrolsulfonsäure und die entsprechenden teil- oder perfluorierten Derivate dieser Säuren.

Beispiele für araliphatische Sulfonsäuren sind Benzylsulfonsäure, α-Methylbenzylsulfonsäure und die entsprechenden teil- oder perfluorierten Derivate dieser Verbindungen.

Beispiele für carbocyclisch-aromatische Carbonsäuren sind Benzoesäure, Toluol-, Ethylbenzol-, Isopropylbenzol- oder Dimethylbenzolcarbonsäure, Naphthalincarbonsäure oder Anthracencarbonsäure und die entsprechenden teil- oder perfluorierten Derivate dieser Verbindungen.

Beispiele für heterocyclisch-aromatische Carbonsäuren sind Pyridin-, Thiophen- oder Pyrrolcarbonsäure sowie die entsprechenden teil- oder perfluorierten Derivate dieser Verbindungen.

Beispiele für araliphatische Carbonsäuren sind Benzylcarbonsäure, α-Methylbenzylcarbonsäure und Zimtsäure, sowie die entsprechenden teil- oder perfluorierten Derivate dieser Verbindungen.

Vorzugsweise handelt es sich bei $X_1^{\ominus}$ um das einwertige Anion einer organischen Sulfonsäure, insbesondere einer Teilfluor- oder Perfluorsulfonsäure. Diese Anionen zeichnen sich durch eine besonders geringe Nucleophilie aus.

Spezielle Beispiele für geeignete Sulfoniumsalze der Formel VIII sind Triphenylsulfoniumbromid, Triphenylsulfoniumchlorid, Triphenylsulfoniumiodid, Triphenylsulfoniumhexafluorphosphat, Triphenylsulfoniumhexafluorantimonat, Triphenylsulfoniumhexafluorarsenat, Triphenylsulfoniumtrifluormethansulfonat, Diphenylethylsulfoniumchlorid, Phenacyldimethylsulfoniumchlorid, Phenacyltetrahydrothiopheniumchlorid, 4-Nitrophenacyltetrahydrothiopheniumchlorid und 4-Hydroxy-2-methylphenylhexahydrothiopyryliumchlorid. Besonders bevorzugt ist Triphenylsulfoniumtrifluormethansulfonat.

Als Verbindungen ii) können auch Iodoniumsalze der Formel IX

$$[Ar_2\text{-}I^{\oplus}\text{-}Ar_3]X_2^{\ominus} \quad (IX)$$

verwendet werden, worin

$Ar_2$ und $Ar_3$ unabhängig voneinander unsubstituiertes oder durch $C_1$-$C_4$-Alkyl, $C_1$-$C_4$-Alkoxy, Halogen und/oder Nitro substituiertes Phenyl oder Naphthyl sind oder $Ar_2$ oder $Ar_3$ zusammen eine Gruppe der Formel X

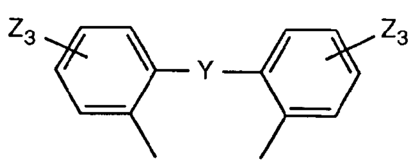

(X)

darstellen, worin $Z_3$ $C_1$-$C_4$-Alkyl, $C_1$-$C_4$-Alkoxy, Halogen oder Nitro und Y eine Direktbindung, -O-, $-CH_2-$ oder -CO- darstellen und $X_2^{\ominus}$ ein Chlorid-, Bromid- oder Iodidanion bedeutet. Iodoniumsalze der Formel IX sind z.B. in der GB-A 1539 192 beschrieben.

Als Verbindungen ii) eignen sich auch unter aktinischer Strahlung Sulfonsäure erzeugende Substanzen der Formeln XI bis XVII

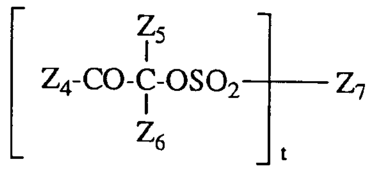

(XI),

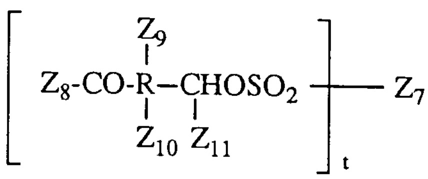

(XII),

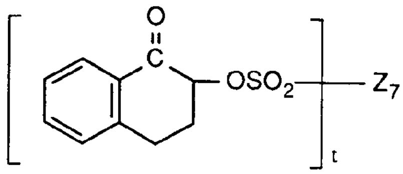

(XIII),

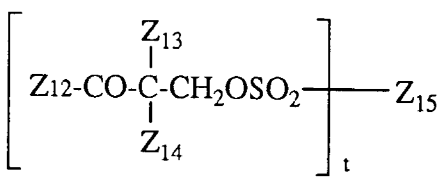

(XIV),

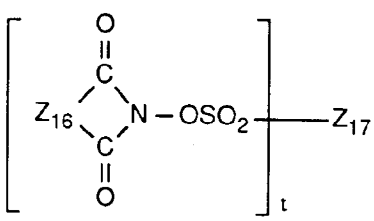

(XV)

$[Z_{18}CON(Z_{14})\text{-}OSO_2]_t\text{—}Z_{17}$ (XVI) und

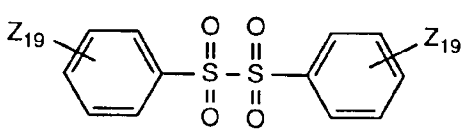

(XVII),

worin

t 1 oder 2, bevorzugt 1 ist,

$Z_4$ unsubstituiertes oder durch 1-3 -Cl, -Br, -CN, $-NO_2$, $C_1$-$C_4$-Alkyl, $C_1$-$C_4$-Alkoxy, $C_1$-$C_4$-Alkylthio, Phenoxy, Phenylthio, $C_1$-$C_4$-Alkylamino, $C_2$-$C_4$-Dialkylamino oder Benzoyl substituiertes Phenyl oder Naphthyl, besonders unsubstituiertes oder einfach durch -Cl, Methyl oder Methoxy substituiertes Phenyl darstellt,

$Z_5$ Wasserstoff oder $C_1$-$C_4$-Alkyl und

$Z_6$ Wasserstoff, $C_1$-$C_4$-Alkyl oder Phenyl bedeuten oder

$Z_5$ und $Z_6$ zusammen mit dem Bindungs-C-Atom einen Cyclopentan- oder Cyclohexanring bilden,
$Z_7$, bei t = 1, $C_1$-$C_8$-Alkyl, unsubstituiertes oder durch $C_1$-$C_4$-Alkyl substituiertes Phenyl oder Naphthyl, Cyclopentyl, Cyclohexyl oder Campheryl und bei t = 2 $C_2$-$C_8$-Alkylen oder Phenylen bedeutet,
$Z_8$ unsubstituiertes oder durch 1-3 -Cl, -Br, $C_1$-$C_4$-Alkyl, $C_1$-$C_4$-Alkoxy, $C_1$-$C_4$-Alkylthio, Phenyl, Phenoxy, Phenylthio, $C_1$-$C_4$-Alkyl-CONH-, Benzoylamino, Dimethylamino substituiertes Phenyl oder Naphthyl, besonders unsubstituiertes oder einfach durch -Cl, $C_1$-$C_4$-Alkoxy, Methylthio oder Phenyl substituiertes Phenyl ist,
$Z_9$ -OH oder $C_1$-$C_4$-Alkyl ist,
$Z_{10}$ $C_1$-$C_4$-Alkyl oder Phenyl ist,
$Z_{11}$ Wasserstoff, $C_1$-$C_4$-Alkyl, Furyl oder -$CCl_3$ bedeutet oder
$Z_{10}$ und $Z_{11}$ zusammen mit dem Bindungs-C-Atom einen Cyclopentan- oder Cyclohexanring bilden,
$Z_{12}$ und $Z_{13}$ unabhängig voneinander unsubstituiertes oder durch Halogen, $C_1$-$C_4$-Alkyl oder $C_1$-$C_4$-Alkoxy substituiertes Phenyl sind,
$Z_{14}$ Wasserstoff oder $C_1$-$C_4$-Alkyl darstellt,
$Z_{15}$ bei t = 1, $C_1$-$C_6$-Alkyl, Phenyl, Naphthyl oder Benzyl und bei t 2 $C_1$-$C_6$-Alkylen, Phenylen oder Xylylen darstellt,
$Z_{16}$ unsubstituiertes oder durch Halogen, Nitro, $C_1$-$C_4$-Alkyl, $C_1$-$C_4$-Alkoxy oder $C_1$-$C_4$-Alkylthio substituiertes Phenylen oder Naphthylen oder -CH=CH- ist, $Z_{17}$ bei t = 1 $C_1$-$C_{12}$-Alkyl, unsubstituiertes oder durch Halogen, Nitro, $C_1$-$C_4$-Alkyl oder $C_1$-$C_4$-Alkoxy substituiertes Phenyl und bei t = 2 $C_2$-$C_8$-Alkylen oder Phenylen ist,
$Z_{18}$ unsubstituiertes oder durch Halogen, Nitro, -CN, $C_1$-$C_4$-Alkyl, Methoxy, Ethoxy, Dimethylamino oder Benzoyl substituiertes Phenyl oder Naphthyl bedeutet und die $Z_{19}$ unabhängig voneinander $C_1$-$C_4$-Alkyl sind.

Definitionsgemässe Alkyl-, Alkoxy-, Alkylthio-, Alkylamino-, Dialkylamino-, Alkylcarbamoyl- und Alkylengruppen können geradketting oder verzweigt sein, sind aber bevorzugt geradkettig. Halogen bedeutet insbesondere -Cl oder -Br.

Verbindungen der Formel XI bis XVI sind z.B. in den EP-A 0166 682 und 0 085 024 sowie der darin zitierten Literatur beschrieben. Besonders bevorzugte Verbindungen der Formeln XI bis XVI sind Phenacyl-p-methylbenzolsulfonat, Benzoin-p-toluolsulfonat, 3-(p-Toluolsulfonyloxy)-2-hydroxy-2-phenyl-1-phenyl-1-propanon [α-(p-Toluolsulfonyloxy)methylbenzoin], N-(p-Dodecylbenzolsulfonyloxy)-1,8-naphthalimid und N-(Phenylsulfonyloxy)-1,8-naphthalimid.

Weitere geeignete Verbindungen ii) sind o-Nitrobenzaldehyde, die sich unter aktinischer Bestrahlung in o-Nitrosobenzoesäuren umlagern, wie 1-Nitrobenzaldehyd und 2,6-Dinitrobenzaldehyd; α-Halogenacylphenone, wie α,α,α-Trichloracetophenon und p-tert.Butyl-α,α,α-trichloracetophenon, sowie Sulfonsäureester von o-Hydroxyacylphenonen, wie 2-Hydroxybenzophenonmethansulfonat und 2,4-Hydroxybenzophenon-bis-(methansulfonat).

Schliesslich eignen sich als Verbindungen ii) auch solche, die aromatisch gebundenes Chlor oder Brom enthalten, wie sie beispielsweise in der EP-A 0 318 649 beschrieben sind, z.B. Verbindungen der Formel XVIII

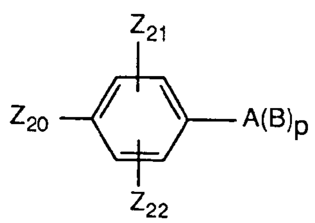

(XVIII)

mit mindestens einem aromatisch gebundenen Chlor- oder Bromatom, worin z.B. p 0 oder 1 bedeutet,
$Z_{20}$ -COOH, -$OZ_{23}$ oder -$SZ_{23}$ ist,
$Z_{21}$ und $Z_{22}$ unabhängig voneinander Wasserstoff, -Cl, -Br, gegebenenfalls durch Aryl, Alkoxy, Aryloxy, -OH oder -F substituiertes Alkyl oder gegebenenfalls durch Alkoxy, Aryloxy, -OH oder Halogen substituiertes Aryl sind,
$Z_{23}$ Wasserstoff, gegebenenfalls analog $Z_{21}$ substituiertes Alkyl oder Aryl oder Acyl ist,
A bei p =0, Wasserstoff, -Cl, -Br, gegebenenfalls analog zu $Z_{21}$ substituiertes Alkyl und bei p = 1, -$SO_2$-, Propylen oder Perfluorallcylen ist und B eine Gruppe

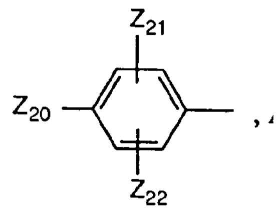

Alkylcarbonyl, Alkoxycarbonyl oder substituiertes Sulfonylimidocarbonyl bedeutet. Beispiele derartiger Verbindungen sind Hexafluortetrabrom-Bisphenol A,1,1,1-Tris(3,5-dibrom-4-hydroxyphenyl)ethan und N-(2,4,6-Tribromphenyl)-N'-(p-toluolsulfonyl)harnstoff.

Besonders bevorzugt verwendet man als Verbindungen ii) solche der Formel VIII, worin $Ar_1$ Phenyl bedeutet, q die Zahl 3 ist, r und s Null sind, und $X_1$ $SbF_6^{\ominus}$, $AsF_6^{\ominus}$, $PF_6^{\ominus}$ und insbesondere das Anion einer aliphatischen, teilfluoraliphatischen oder perfluoraliphatischen Sulfonsäure oder einer aromatischen, teilfluoraromatischen oder perfluoraromatischen Sulfonsäure ist.
Besonders bevorzugte Anionen $X_1^{\ominus}$ sind $CF_3SO_3^{\ominus}$, $C_2F_5SO_3^{\ominus}$, n-$C_3F_7SO_3^{\ominus}$, $C_4F_9SO_3^{\ominus}$, n-$C_6F_{13}SO_3^{\ominus}$, n-$C_8F_{17}SO_3^{\ominus}$ und $C_6F_5SO_3^{\ominus}$. Ganz besonders bevorzugt verwendet mal als Verbindung ii) Triphenylsulfoniumtrifluormethansulfonat.

Die Verbindungen ii) werden zweckmässig in einer Menge von 0,1 bis 20 Gew.%, besonders 1 bis 10 Gew.% und ganz besonders 1 bis 6 Gew.%, bezogen auf das Gewicht des Copolymeren, eingesetzt.

Die erfindungsgemässen Zusammensetzungen können weitere übliche Zusatzstoffe enthalten, wie z.B. Bindemittel, Stabilisatoren, Pigmente, Farbstoffe, Füllstoffe, Haftvermittler, Verlaufmittel, Netzmittel und Weichmacher. Bevorzugt sind die Zusammensetzungen zur Applikation in geeigneten Lösungsmitteln [Komponente iii)] gelöst.

Die Wahl des Bindemittels erfolgt je nach dem Anwendungsgebiet und den hierfür geforderten Eigenschaften. Geeignete Bindemittel sind beispielsweise Novolake, die sich von einem Aldehyd, vorzugsweise Formaldehyd, Acetaldehyd oder Furfuraldehyd, besonders jedoch von Formaldehyd, und einem Phenol ableiten. Die phenolische Komponente dieser Bindemittel ist vorzugsweise Phenol selbst, oder auch halogeniertes Phenol, beispielsweise substituiert mit ein bis zwei Chloratomen, vorzugsweise. p-Chlorphenol, oder sie ist ein durch ein bis zwei $C_1$-$C_9$-Alkylgruppen substituiertes Phenol, beispielsweise o-, m- oder p-Kresol, ein Xylenol, p-tert.Butylphenol oder p-Nonylphenol. Es kann sich bei der Phenokomponente der bevorzugten Novolake aber auch um p-Phenylphenol, Resorcin, Bis-(4-hydroxyphenyl)-methan oder 2,2-Bis(4-hydroxyphenyl)-propan handeln.

Weitere geeignete Bindemittel sind beispielsweise Copolymere von Maleinsäureanhydrid mit Styrol, Vinylethem oder 1-Alkenen. Homo- oder copolymere Acrylate und Methacrylate, z.B. Copolymere aus Methylmethacrylat/Ethylacrylat/Methacrylsäure, Poly(methacrylsäurealkylester) oder Poly(acrylsäurealkylester) mit z.B. 1-20 C-Atomen im Alkylrest lassen sich ebenfalls als Bindemittel einsetzen.

Vorzugsweise verwendet man als Bindemittel eine alkalilösliche Substanz, beispielsweise einen Novolak (gegebenenfalls modifiziert wie oben beschrieben), Poly(4-hydroxystyrol) oder Poly(4-hydroxy-3,5-dimethylstyrol), Copolymere von Maleinsäureanhydrid mit Styrol, Vinylethem oder 1-Alkenen, sowie Copolymere von Acrylsäure- oder Methacrylsäureestern mit ethylenisch ungesättigten Säuren, beispielsweise Methacrylsäure oder Acrylsäure.

Die in einem Lösungsmittel oder Lösungsmittelgemisch gelösten erfindungsgemässen strahlungsempfindlichen Zusammensetzungen eignen sich hervorragend als Beschichtungsmittel für Substrate aller Art, z.B. Holz, Textilien, Papier, Keramik, Glas, Kunststoffe, wie Polyester, Polyethylenterephthalat, Polyolefine oder Celluloseacetat, insbesondere in Form von Filmen, sowie Metalle, wie Al, Cu, Ni, Fe, Zn, Mg oder Co, und GaAs, Si oder $SiO_2$, auf denen durch bildmässiges Belichten eine Abbildung aufgebracht werden soll.

Die Wahl des Lösungsmittels und die Konzentration richten sich hauptsächlich nach der Art der Zusammensetzung und nach dem Beschichtungsverfahren. Das Lösungsmittel soll inert sein, d.h. es soll mit den Komponenten keine chemische Reaktion eingehen und es soll bei der Trocknung nach dem Beschichten wieder enfernt werden können. Geeignete Lösungsmittel sind z.B. Ketone, Ether und Ester, wie Methylethylketon, Isobutylmethylketon, Cyclopentanon, Cyclohexanon, N-Methylpyrrolidon, Dioxan, Tetrahydrofuran, 2-Methoxyethanol, 2-Ethoxyethanol, 1-Methoxy-2-propanol, 1,2-Dimethoxyethan, Essigsäureethylester, Essigsäure-n-butylester und 3-Ethoxy-propionsäureethylester.

Die Lösung wird mittels bekannter Beschichtungsverfahren gleichförmig auf ein Substrat aufgebracht, z.B. durch Schleudern, Tauchen, Rakelbeschichtung, Vorhanggiessverfahren, Aufpinseln, Sprühen, speziell durch elektrostatisches Sprühen und Reverse-Rollbeschichtung. Es ist auch möglich, die lichtempfindliche Schicht auf einen temporären, flexiblen Träger zu bringen und dann durch Schichtübertragung via Lamination das endgültige Substrat, z.B. eine kupferkaschierte Leiterplatte, zu beschichten.

Die Auftragsmenge (Schichtdicke) und die Art des Substrats (Schichtträger) sind vom gewünschten Applikationsgebiet abhängig. Der Schichtdickenbereich umfasst im allgemeinen Werte von ca. 0,1 µm bis mehr als 10 µm.

Die erfindungsgemässen strahlungsempfindlichen Zusammensetzungen finden Anwendung als Negativresist, die eine sehr hohe Lichtempfindlichkeit aufweisen und schwellungsfrei in wässrig-alkalischem Medium enwickelt werden können. Sie eignen sich als Photoresists für die Elektronik (Galvanoresist, Aetzresist, Lötstopresist), die Herstellung von Druckplatten, wie Offsetdruckplatten oder Siebdruckformen, den Einsatz beim Formteilätzen oder den Einsatz als Mikroresist bei der Herstellung integrierter Schaltkreise. Dementsprechend unterschiedlich sind die möglichen Schichtträger und die Verarbeitungsbedingungen der beschichteten Substrate.

Für photographische Informationsaufzeichnungen dienen z.B. Folien aus Polyester, Celluloseacetat oder mit Kunststoff beschichtete Papiere; für Offsetdruckformen speziell behandeltes Aluminium, für die Herstellung gedruckter Schaltungen kupferkaschierte Laminate und für die Herstellung von integrierten Schaltkreisen Siliziumwafer. Die Schichtdicken für photographische Materalien und Offsetdruckformen betragen in der Regel ca. 0,5 µm bis 10 µm, für gedruckte Schaltungen 0,4 bis ca. 2 µm.

Mit den erfindungsgemässen Zusammensetzungen können hoch aufgelöste Reliefstrukturen negativer Tonalität hergestellt werden. Dank der hohen Empfindlichkeit und der hohen optischen Transparenz bzw. der geringen optischen Absorption im UV-Bereich um 250 nm eignen sie sich insbesondere für Anwendungen in der Mikrolithographie, vor allem der Tief-UV-Mikrolithographie. Dank dieser Eigenschaften las sen sich sehr steile Wandprofile und die Auflösung von Submikronstrukturen (bis auf 0,5 µm) erzielen. Derartige Submicronstrukturen können z.B. mit entsprechenden Zusammensetzungen enthaltend eine Acetoxymethylfunktion im Copolymermolekül nicht hergestellt werden. Nach dem Beschichten der Substrate wird das Lösungsmittel in der Regel durch Trocknen entfernt, und es resultiert eine Schicht des Photoresists auf dem Träger.

Der Begriff "bildmässige" Belichtung beinhaltet sowohl die Belichtung durch eine Photomaske, die ein vorbestimmtes Muster enthält, beispielsweise ein Diapositiv, die Belichtung durch einen Laserstrahl, der beispielsweise computergesteuert über die Oberfläche des beschichteten Substrats bewegt wird und auf diese Weise ein Bild erzeugt, sowie die Bestrahlung mit computergesteuerten Elektronenstrahlen.

Die Lichtempfindlichkeit der erfindungsgemässen Zusammensetzungen reicht in der Regel vom UV-Gebiet (ca. 200 nm) bis ca. 600 nm und umspannt somit einen sehr breiten Bereich. Als Lichtquellen kommen daher eine grosse Anzahl der verschiedensten Typen zur Anwendung. Es sind sowohl Punktquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen, photographische Flutlichtlampen, Elektronenstrahlen und Röntgenstrahlen, erzeugt mittels Synchrotronen oder Laser-Plasma.
Der Abstand zwischen Lampe und erfindungsgemässem Bildmaterial kann je nach Anwendungszweck und Lampentyp bzw. -stärke variieren, z.B. zwischen 2 cm bis 150 cm. Speziell geeignet sind Laserlichtquellen, z.B. Excimer-Laser, wie KriptonFluorid-Laser zur Belichtung bei 248 nm. Hier ist die hohe Empfindlichkeit der erfindungsgemässen Materialien sehr vorteilhaft. Nach dieser Methode können gedruckte Schaltungen in der Elektronikindustrie, lithographische Offsetdruckplatten oder Reliefdruckplatten sowie photographische Bildaufzeichnungsmaterialien hergestellt werden.

Nach der bildmässigen Belichtung des Materials und vor der Entwicklung kann es vorteilhaft sein, für kürzere Zeit eine thermische Behandlung durchzuführen. Dabei werden nur die belichteten Teile thermisch gehärtet. Die angewandten Temperaturen liegen im allgemeinen bei 50-150°C, bevorzugt bei 80-130°C; die Zeit für die thermische Behandlung liegt in der Regel zwischen 0,25-10 Minuten.

Nach der Belichtung und gegebenenfalls thermischen Behandlung werden die unbelichteten Stellen des Photolacks in an sich bekannter Weise mit einem Entwickler entfernt.

Die erfindungsgemässen Zusammensetzungen sind - wie schon erwähnt - wässrigalkalisch entwickelbar. Geeignete wässrig-alkalische Entwickler-Lösungen sind insbesondere wässrige Lösungen von Tetraalkylammoniumhydroxiden oder von Alkalimetallsilikaten, -phosphaten, -hydroxiden und -carbonaten. Diesen Lösungen können gegebenenfalls noch kleinere Mengen an Netzmitteln und/oder organischen Lösungsmitteln zugesetzt sein. Typische organische Lösungsmittel, die den Entwicklerflüssgkeiten in kleinen Mengen zugesetzt werden können, sind beispielsweise Cyclohexanon, 2-Ethoxyethanol, Toluol, Aceton sowie Mischungen solcher Lösungsmittel.

Die erfindungsgemässen Zusammensetzungen eignen sich insbesondere zur Herstellung von Druckplatten, gedruckten Schaltungen und integrierten Schaltkreisen.

Die folgenden Beispiele erläutern die Erfindung näher.

Beispiel 1: Herstellung von 4-Vinylbenzaldehyd.

In einem 250 ml 3-Halsrundkölben mit Rückflusskühler, mechanischem Rührer, Innenthermometer und Stickstoff-Ueberleitung werden zu einer Mischung aus 6,5 g (268 mMol) Magnesiumspänen in 100 ml Tetrahydrofuran (THF) langsam 18,4 g (133 mMol) 4-Chlorstyrol getropft. Die Reaktionsmischung wird während 1 Stunde auf 50°C gehalten und danach tropfenweise mit einer Lösung von 9,8 g (134 mMol) Dimethylformamid in 50 ml THF versetzt. Nach 12 Stunden bei Raumtemperatur wird auf Eis gegossen und mit Diethylether extrahiert. Die organische Phase wird zweimal mit Wasser gewaschen, über Magnesiumsulfat getrocknet und eingeengt, wobei 18,3 g Produkt als blassgelbes Oel anfallen. Nach der Reinigung mittels Säulenchromatographie (Silicagel, Hexan/Diethylether 4: 1) erhält man 12,6 g (95,3 mMol, 72 % d.Th.) 4-Vinylbenzaldehyd.
$^1$H-NMR ($CDCl_3$, 100 mHz): δ 9,95/s, 7,80/d (J = 9 Hz), 7,49/d (J = 9 Hz), 6,74/dd ($J_1$ = 18 Hz, $J_2$ = 11 Hz), 5,87dd ($J_1$ = 18 Hz, $J_2$ = 2 Hz), 5,39/dd ($J_1$ = 11 Hz, $J_2$ = 2 Hz).

Beispiel 2: Herstellung von 2-(4-Ethenylphenyl)- 1,3-dioxolan.

In einem 250 ml 3-Halsrundkolben werden 100 ml Toluol mit 13,72 g (103 mMol) 4-Vinylbenzaldehyd, 7,08 g (114 mMol) Ethylenglykol und 0,23 g (1,3 mMol) p-Toluolsulfonsäure versetzt. Das resultierende Gemisch wird während 3 Std. unter reduziertem Druck bei 45°C am Wasserabscheider rückflussiert. Danach wird zweimal mit 100 ml Wasser gewaschen, die organische Phase wird über Magnesiumsulfat getrocknet und eingeengt, wobei 17,47 g Rohprodukt als blassgelbes Oel anfallen. Diese wird bei 80°C/0,05 mbar destilliert. Ausbeute: 12,81 g (72,7 mMol, 70,6 % d.Th).
$^1$H-NMR ($CDCl_3$, 100 mHz): δ 7,39/s/4H, 6,68/dd ($J_1$ = 11 Hz, $J_2$ = 18 Hz)/1H, 5,74/s/1H, 5,72 ($J_1$ = 18 Hz, $J_2$ = 2 Hz)/1H, 5,22/dd ($J_1$ = 11 Hz, $J_2$ = 2 Hz)/1H, 3,96/m/4H.

Beispiel 3: Herstellung von 4-Hydroxystyrol.

In einem 1-Liter Sulfierkolben mit mechanischem Rührer, Rückflusskühler und Stickstoff-Ueberleitung werden 150 g (0,91 Mol) 4-Hydroxyzimtsäure, 6 g (54 mMol) Hydrochinon und 6 g (39 mMol) 1,8-Diazabicyclo[5.4.0]undecen-7 mit 300 ml Dimethylsulfoxid versetzt. Die Mischung wird danach während 3 1/2 Std. auf 135°C erhitzt. Nach dem Abkühlen giesst man auf Eis, extrahiert dreimal mit 500 ml Diethylether, wäscht die organische Phase fünfmal mit 100 ml Wasser, trocknet über Magnesiumsulfat und engt ein. Das resultierende Oel wird zweimal aus n-Hexan umkristallisiert, wobei 69,07 g (0,58 Mol, 63 % d.Th.) 4-Hydroxystyrol als weisses Pulver anfallen (Smp. 68°C).
$^1$H-NMR ($CDCl_3$, 100 mHz): δ 9,52/s/1H, 7,26/d (J = 9 Hz)/2H, 6,69/d (J = 9 Hz)/2H, 6,6/dd ($J_1$ = 18 Hz, $J_2$ = 12 Hz)/1H, 5,58/dd ($J_1$ = 18 Hz, $J_2$ = 2 Hz)/1H, 5,02/dd ($J_1$ = 12 Hz, $J_2$ = 2 Hz)/1H.

Elementaranalyse

| | | |
|---|---|---|
| berechnet | C 79,97 % | H 6,71 % |
| gefunden | C 79,11 % | H 6,82 %. |

Beispiel 4: Herstellung von 4-Tetrahydropyran-2-yloxystyrol.

In einem 250 ml Rundkolben werden 15 g (125 mMol) 4-Hydroxystyrol und 0,4 g (2,3 mMol) p-Toluolsulfonsäure-monohydrat in 120 ml Diethylether gelöst. Dann werden bei 5°C 11,6 g (137 mMol) 3,4-Dihydro-2H-pyran über eine Zeitspanne von 10 Minuten zugetropft. Man lässt Raumtemperatur erreichen und rührt während 20 Std. weiter. Danach wird mit 1N NaOH-Lösung versetzt, die organische Phase wird zweimal mit Wasser gewaschen, über Magnesiumsulfat getrocknet und eingeengt. Dabei resultieren 23,3 g (114 mMol, 90 % d.Th.) 4-Tetrahydropyran-2-yloxystyrol als farbloses Oel, welches ohne weitere Reinigung für die Copolymerisation verwendet wird.
$^1$H-NMR ($CDCl_3$, 100 mHz): δ 7,37/d (J = 9 Hz)/2H, 7,02/d (J = 9 Hz)/2H, 6,52/dd ($J_1$ = 18 Hz, $J_2$ = 11 Hz)/1H, 5,50/dd ($J_1$ = 18 Hz, $J_2$ = 2 Hz)/1H, 5,41/m/1H, 5,11/dd ($J_1$ = 11 Hz, $J_2$ = 2 Hz)/1H, 4,0-3,7/m/1H, 3,7-3,4/m/1H, 2,2- 1,2/m/6H.

Elementaranalyse:

| | | |
|---|---|---|
| berechnet | C 76,44 % | H 7,90 % |
| gefunden | C 74,81 % | H 7,89 %. |

Beispiel 5: Herstellung von 2-(4-Ethenylphenyl)-1,3,5,5-dimethyldioxan.

In einem 250 ml 3-Halsrundkolben werden 65 ml Toluol mit 10,0 g (75,7 mMol) 4-Vinylbenzaldehyd, 8,67 g (83 mMol) 2,2-Dimethyl-1,3-propandiol und 0,15 g (0,9 mMol) p-Toluolsulfonsäure versetzt. Das Gemisch wird während 5 Stunden am Wasserabscheider rückflussiert und danach mit 50 ml 0,1 N Natronlauge versetzt. Die organiche Phase wird abgetrennt, dreimal mit Wasser gewaschen, über Magnesiumsulfat getrocknet und eingeengt. Das anfallende Rohprodukt wird aus Methanol/Wasser umkristallisiert. Ausbeute: 10,9 g (45,8 mMol; 60,5% d.Th) in Form weisser Kristalle. Schmelzpurikt: 45-46°C.
$^1$H-NMR ($CDCl_3$, 100 MHz): δ 7,46/d/2H, 7,39/d/2H, 6,71/dd/1H, 5,75/d/1H, 5,38/s/1H, 5,24/d/1H, 3,77/d/2H, 3,64/d/2H, 1,29/s/3H, 0,80/s/3H.

Beispiel 6: Herstellung von 4-Ethenylphenyl-di-n-propoxymethan.

In einem 100 ml 3-Halsrundkolben werden 6,8 g (51,5 mMol) 4-Vinylbenzaldehyd, 12,4 g (205,8 mMol) n-Propanol und 0,1 g (0,5 mMol) p-Toluolsulfonsäure in 45 ml Benzol gelöst. Die Lösung wird während 22 Stunden am Wasserabscheider rücflkussiert und danach mit Ether versetzt. Anschliessend wird mit 0,1 N Natronlauge neutralisiert. Die organische Phase wird nun dreimal mit Wasser gewaschen, über Magnesiumsulfat getrocknet und eingeengt. Das resultierende Oel lässt sich säulenchromatographisch reinigen (stat. Phase Silicagel, mob. Phase Hexan-Ether 5/4), wobei 2,54 g (10,8 mMol, 21 % d.Th) der gewünschten Substanz als klares Oel anfallen.
$^1$H-NMR ($CDCl_3$, 100 MHz): δ 7,41/m/4H, 6,71/dd/1H, 5,89/d/1H, 5,50/s/1H, 5,23/d/1H, 3,46/m/4H, 1,62/m/4H, 0,94/t/6H.

Beispiel 7: Copolymerisation von 4-Hydroxystyrol und 2-(4-Ethenylphenyl)- 1,3-dioxolan.

1,8 g (10 mMol) 2-(4-Ethenylphenyl)-1,3-dioxolan und 2,4 g (20 mMol) 4-Hydroxystyrol werden mit 0,1 g α,α'-Azoisobutyronitril in 17 g frisch destilliertem THF bei 70°C während 24 Stunden radikalisch copolymerisiert. Nach zweimaligem Ausfällen aus 400 ml n-Hexan wird das Produkt als weisses Pulver isoliert; Ausbeute 2,5 g (60 % d.Th.).
$^1$H-NMR (DMSO, 300 mHz): δ 8,9/s, 7,3-6,9/m, 6,8-6,0/m, 5,7-5,5/m, 4,1-3,8/m, 2,0-0,9/m.
Einbauverhältnis 4-Hydroxystyrol/2-(4-Ethenylphenyl)- 1,3-dioxolan = 1:1 ($^1$H-NMR). Durch Gelpermeationschromatographie (GPC, Polystyroleichung) werden ermittelt: Mn = 4870, Mw = 12410, Mw/Mn = 2,5.
Tg = 84°C, ermittelt durch Differential Scanning Calorimetriy, DSC ( 10°/Min).

Beispiel 8: Copolymerisation von 4-Hydroxystyrol und 2-(4-Ethenylphenyl)- 1,3-dioxolan.

1,8 g (10 mMol) 2-(4-Ethenylphenyl)-1,3-dioxolan und 6,0 g (50 mMol) 4-Hydroxystyrol werden mit 0,23 g α,α'-Azobisisobutyronitril in 31 g frisch destilliertem THF während 24 Stunden bei 70°C copolymerisiert. Das Copolymer wird durch zweimaliges Ausfällen aus 600 ml n-Hexan als weisses Pulver isoliert; Ausbeute 5,0 g (64 % d.Th.).
$^1$H-NMR ($CDCl_3$, 300 MHz): δ 8,4/s, 7,3-6,9/m, 6,9-6,1/m, 5,8-5,7/m, 4,1-3,9/m, 2,0-0,9/m.
Einbauverhältnis 4-Hydroxystyrol/2-(4-Ethenylphenyl)-1,3-dioxolan = 4:1 ($^1$H-NMR).
GPC (Polystyroleichung): Mn = 2260, Mw = 9160, Mw/Mn = 4,2.

Beispiel 9: Copolymerisation von 4-Tetrahydropyran-2-yloxystyrol mit 2-(4-Ethenyl)-1,3-dioxolan.

6,1 g (30 mMol) 4-Tetrahydropyran-α-yloxystyrol und 1,8 g (10 mMol) 2-(4-Ethenyl)- 1,3-dioxolan werden mit 0, 18 g α,α'-Azoisobutyronitril in 32 g Toluol während 24 Stunden bei 70°C copolymerisiert. Nach zweimaligem Ausfällen in Methanol erhält man 4,9 g (62 % d.Th.) des Copolymeren in Form eines weissen Pulvers.
$^1$H-NMR ($CDCl_3$, 300 MHz): δ 7,4-6,1/m, 5,8-5,6/bs, 5,2-5,5/bs, 4,2-3,8/m, 3,7-3,4/bs, 2,2- 1,0/m.
Einbauverhältnis 4-Tetrahydropyran-2-yloxystyrol/2-(4-Ethenylphenyl)- 1,3-dioxolan = 2: 1 ($^1$H-NMR).

GPC: Mn = 6210, Mw = 14730, Mw/Mn = 2,4.

Das Phenol in den Strukturelementen aus 4-Tetrahydropyran-2-yloxystyrol wird durch 60-minütiges Rühren in Tetrahydrofuran unter Inertgasatmosphäre in Gegenwart einer katalytischen Menge Essigsäure bei Raumtemperatur freigesetzt.

Beispiel 10: Copolymerisation von 4-Hydroxystyrol und 4-Ethenylphenyl-di-n-propoxymethan.

In einem 100 ml Rundkolben werden 2,34 g (10 mMol) 4-Ethenylphenyl-di-n-propoxymethan, 6,0 g (50 mMol) 4-Hydroxystyrol und 0,25 g α,α'-Azoisobutyronitril in 33 g Tetrahydrofuran gelöst. Man lässt während 24 Stunden rückflussieren und fällt danach in der 10-fachen Menge n-Hexan aus. Dabei resultieren 6,12 g (73 % d.Th) eines weissen Pulvers.
GPC (Polystyroleichung): Mn = 2860, Mw = 12940, Mw/Mn = 4,5.
DSC (10°/min): Tg = 51°C.

Beispiel 11: Copolymerisation von 4-Hydroxystyrol mit 4-(2-Ethenylphenyl- 1,3,5,5-dimethyldioxan.

In einem 100 ml Rundkolben werden 2,18 g (10 mMol) 4-(2-Ethenylphenyl-1,3,5,5-dimethyldioxan, 6,0 g (50 mMol) 4-Hydroxystyrol und 0,25 g α,α'-Azoisobutyronitril in 32 g Tetrahydrofuran gelöst. Nach 24 Stunden Kochen unter Rückfluss wird aus n-Hexan gefällt, das resultierende weisse Pulver in Tetrahydrofuran gelöst und erneut aus der zehnfachen Menge n-Hexan gefällt, wobei 5,5 g (67 % d.Th) eines weissen Pulvers resultieren.
GPC (Polystyroleichung): Mn = 5480, Mw = 13410, Mw/Mn = 2,4.
DSC (10°/min): Tg = 53°C.
$^1$H-NMR (Aceton-$d_6$, 100 MHz): 6 8,0, 7,3, 6,6, 5,4, 3,7, 2,1-1,1, 1,3.
Einbauverhältnis 4-(2-Ethenylphenyl)-1,3,5,5-dimethyldioxan/4-Hydroxystyrol = 1:3 (ermittelt durch $^1$H-NMR-Spektroskopie).

Beispiel 12:

Durch Auflösen von 90 Gew.teilen des Copolymeren gemäss Beispiel 7 und 10 Gew.teilen Triphenylsulfoniumtrifluormethansulfonat in 350 Gew.teilen Cyclopentanon wird eine Resistmischung bereitgestellt. Diese Mischung wird auf einen Siliziumwafer aufgeschleudert und bei 120°C während 2 Min. getrocknet. Dabei erhält man einen Resistfilm mit einer Schichtdicke von 1,0 μm, der anschliessend durch eine Quarzmaske bildmässig belichtet wird. Als Lichtquelle verwendet man eine Quecksilberdampflämpe, welche während 3 Sekunden eingeschaltet bleibt. Nach der Belichtung wird während 3 Min. auf 90°C erwärmt und danach in einer Lösung von 15 Gew.% Tetramethylammoniumhydroxid in Wasser entwickelt. Dabei bleiben die belichteten Stellen des Films als Reliefstrukturen der ursprünglichen Dicke erhalten, während die unbelichteten Stellen aufgelöst werden. Das erhaltene Resistmaterial erlaubt die Auflösung von Submikronstrukturen.

Beispiel 13:

Durch Auflösen von 96 Gew.teilen des Copolymeren gemäss Beispiel 8 und 5 Gew.teilen Triphenylsulfonium-trifluormethansulfonat in 250 Gew.teilen Cyclohexanon wird eine Resistlösung bereitgestellt. Die Lösung wird auf eine Siliziumscheibe aufgeschleudert und danach während 2 Minuten bei 120°C getrocknet. wobei man einen Resistfilm einer Dicke von 1,1 μm erhält. Die optische Dichte dieses Films, gemessen auf einer Quarzscheibe, weist bei 248 nm einen Wert von 0,32 auf. Der mit dem Resistfilm. beschichtete Wafer wird nun durch eine Quarzmaske mit Interferenz-Engbandfilter bei 254 nm und einer Dosis von 20 mJ/cm$^2$ kontaktbelichtet und anschliessend während 1 Min. auf 120°C erwärmt. Bei der nachfolgenden Entwicklung in einer 2,38 gew.prozentigen wässrigen Lösung von Tetramethylammoniumhydroxid bleiben die belichteten Stellen des Films als Reliefstrukturen der ursprünglichen Dicke zurück, während die unbelichteten Stellen aufgelöst werden. Das erhaltene Resistmaterial ist bei einem Kontraswert y von 3,0 in der Lage, Strukturen bis auf 0,5 Mikrometer l/s (lines and spaces) liniengetreu und schwellungsfrei wiederzugeben.

Beispiel 14:

Auf eine kupferkaschierte Leiterplatte wird die gemäss Beispiel 11 erhaltene Resistlösung durch Pinseln aufgetragen und im Wärmeschrank während 15 Min. bei 100°C getrocknet, wobei Resistfilme mit einer Schichtdicke von 15 μm resultieren. Danach wird durch eine Maske mit einer Quecksilberdampfdrucklampe während

15 Sekunden belichtet, und die Platte wird anschliessend während 2 Min. auf 120°C gehalten. Anschliessend wird in einer 2,38 gew.prozentigen Lösung von Tetramethylammoniumhydroxid in Wasser während 1 Minute entwickelt, wobei die belichteten Stellen des Resitfilms zurückbleiben und die unbelichteten Stellen aufgelöst werden.

## Patentansprüche

1. Säurekatalytisch vernetzbares Copolymer mit einem Molekulargewicht (Mw) von $10^3$ bis $10^6$, gemessen mittels Gelpermeationschromatographie, das aus
   a) 100-80 Mol.% wiederkehrender Strukturelemente der Formeln I und II

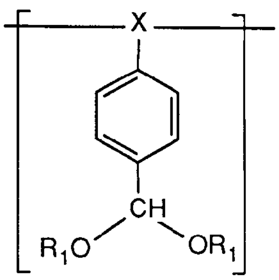

(I)

und

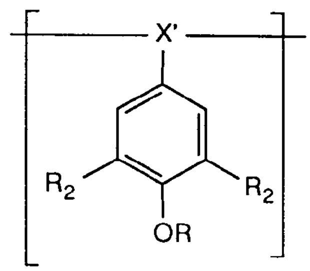

(II)

   im Verhältnis von 1:1 bis 1:9 und
   b) 0-20 Mol.% wiederkehrender Strukturelemente der Formel III

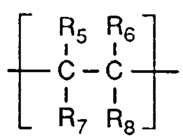

(III)

   besteht, worin
   X und X′ unabhängig voneinander

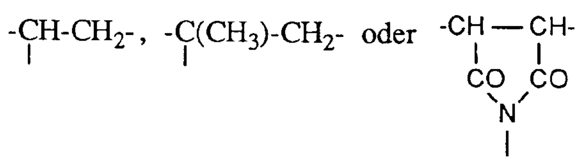

, , oder

   bedeuten,
   R Wasserstoff oder eine unter Säureeinwirkung abspaltbare Schutzgruppe ist, die $R_1$ unabhängig voneinander $C_1$-$C_5$-Alkyl, Phenyl oder Naphthyl bedeuten oder zusammen 1,2-Phenylen oder $-[C(R_3)(R_4)]_x-$ mit $R_3$ und/oder $R_4$ = Wasserstoff oder Methyl und x = 2 bis 5 darstellen,
   die $R_2$ unabhängig voneinander Wasserstoff, $C_1$-$C_5$-Alkyl oder $C_1$-$C_5$-Alkoxy darstellen,
   $R_5$ und $R_7$ je Wasserstoff sind,
   $R_6$ Wasserstoff, Halogen oder Methyl und
   $R_8$ Wasserstoff, Halogen, Methyl, $-CH_2$Halogen, $-CH_2CN$, -CN, -COOH, $-CONH_2$, -O-$C_1$-$C_5$-Alkyl, -O-CO-$C_1$-$C_5$-Alkyl, -COO-$C_1$-$C_5$-Alkyl, -COO-Phenyl oder Phenyl bedeuten,
   oder $R_5$ und $R_5$ je Wasserstoff sind und $R_7$ und $R_5$ zusammen -CO-O-CO- oder unabhängig voneinander -COOH oder -COO-$C_1$-$C_5$-Alkyl, darstellen.

2. Copolymer gemäss Anspruch 1, das aus 100-90 Mol.% wiederkehrender Strukturelemente der Formeln I und II und aus 0-10 Mol.% wiederkehrender Strukturelmente der Formel III besteht.

3. Copolymer gemäss Anspruch 1, worin X und X′

$$-C(CH_3)-CH_2-$$

und insbesondere je

$$-CH-CH_2-$$

darstellen.

4. Copolymer gemäss Anspruch 1, worin die $R_1$ zusammen $-[C(R_3)(R_4)]_x-$ und $R_2$ je Wasserstoff, Methyl, Ethyl, Methoxy oder Ethoxy bedeuten.

5. Copolymer gemäss Anspruch 1, worin R ein Rest der Formeln IV, V, VI oder VII

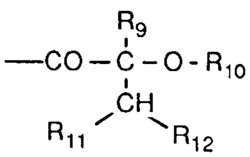 (IV), 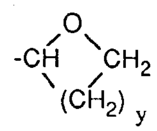 (V), $-COO-C(CH_3)_3$ (VI) oder

$-CO-R_{13}$ (VII) ist, worin
$R_9$ Wasserstoff oder Methyl ist,
$R_{10}$ $C_1$-$C_5$-Alkyl, Phenyl oder Naphthyl bedeutet und $R_{11}$ und $R_{12}$ unabhängig voneinander Wasserstoff, $C_1$-$C_5$-Alkyl, Phenyl oder Naphthyl sind, oder
$R_{10}$ und $R_{12}$ zusammen unsubstituiertes oder durch $C_1$-$C_4$-Alkyl, $C_1$-$C_4$-Alkoxy, Phenyl, Naphthyl, Phenoxy oder Naphthyloxy substituiertes Ethylen, Propylen oder Butylen darstellen,
y für 2, 3 oder 4 steht, und
$R_{13}$ $C_1$-$C_5$-Alkyl oder $C_1$-$C_5$-Alkoxy bedeutet.

6. Copolymer gemäss Anspruch 5, worin R $-COO-C(CH_3)_3$ und insbesondere einen Rest der Formel V mit y = 2 oder 3 darstellt.

7. Copolymer gemäss Anspruch 1, worin X und X′

$$-CH-CH_2-,$$

R und die beiden $R_2$ je Wasserstoff und die $R_1$ zusammen $-[C(R_3)(R_4)]_x-$ mit x = 2 bis 4, besonders 2 oder 3, bedeuten.

8. Strahlungsempfindliche Zusammensetzung enthaltend
   i) mindestens ein Copolymer gemäss Anspruch 1 und
   ii) mindestens eine unter aktinischer Strahlung säurebildende Verbindung.

9. Zusammensetzung nach Anspruch 8, enthaltend als weitere Komponente iii) ein Lösungsmittel oder ein Lösungsmittelgemisch.

10. Zusammensetzung nach Anspruch 8, worin das Copolymer i) aus 100-90 Mol.% wiederkehrender Strukturelemente der Formeln I und II und aus 0-10 Mol.% wiederkehrender Strukturelemente der Formel III besteht.

11. Zusammensetzung nach Anspruch 8, worin X und X′ im Copolymer i)

$$-C(CH_3)-CH_2-$$

und insbesondere je

$$-\underset{|}{C}H-CH_2-$$

darstellen.

**12.** Zusammensetzung nach Anspruch 8, worin R im Copolymer i) $-COO-C(CH_3)_3$ und insbesondere einen Rest der Formel V mit y = 2 oder 3 darstellt.

**13.** Zusammensetzung nach Anspruch 8, worin im Copolymer i) X und X'

$$-\underset{|}{C}H-CH_2-,$$

R und die beiden $R_2$ je Wasserstoff und die $R_1$ zusammen $-[C(R_3)(R_4)]_x-$ mit x = 2 bis 4, besonders 2 oder 3, bedeuten.

**14.** Zusammensetzung nach Anspruch 8, enthaltend als Komponente ii) mindestens eine Verbindung der Formel VIII

$$(Ar_1)_q(Z_1)_r(Z_2)_sS^{\oplus}X_1^{\ominus} \quad \text{(VIII)},$$

worin
$Ar_1$ unsubstituiertes oder durch Halogen, $C_1$-$C_4$-Alkyl, $C_1$-$C_4$-Alkoxy, -OH und/oder Nitro substituiertes Phenyl, Naphthyl oder Phenyl-$COCH_2$- ist,
$Z_1$ $C_1$-$C_6$-Alkyl oder $C_3$-$C_7$-Cycloalkyl und
$Z_2$ Tetrahydrothienyl, Tetrahydrofuryl oder Hexahydropyryl sind,
q für 0, 1, 2 oder 3,
r für 0, 1 oder 2 und
s für 0 oder 1 stehen, wobei die Summe q+r+s 3 beträgt, und
$X_1^{\ominus}$ ein Chlorid-, Bromid- oder Iodidanion, $BF_4^{\ominus}$, $PF_6^{\ominus}$, $AsF_6^{\ominus}$, $SbF_6^{\ominus}$, $FSO^{\ominus}$ oder das Anion einer organischen Sulfonsäure oder Carbonsäure ist.

**15.** Zusammensetzung nach Anspruch 14, worin $Ar_1$ Phenyl bedeutet, q die Zahl 3 ist, r und s Null sind, und $X_1^{\ominus}$ $SbF_6^{\ominus}$, $AsF_6^{\ominus}$, $PF_6^{\ominus}$, $CF_3SO_3^{\ominus}$, $C_2F_5SO_3^{\ominus}$, n-$C_3F_7SO_3^{\ominus}$, n-$C_4F_9SO_3^{\ominus}$, n-$C_6F_{13}SO_3^{\ominus}$, n-$C_8F_{17}SO_3^{\ominus}$ oder $C_6F_5SO_3^{\ominus}$ darstellt.

**16.** Zusammensetzung nach Anspruch 8, worin die Verbindung ii) in einer Menge von 0, 1 bis 20 Gew.%, besonders 1 bis 10 Gew.%, bezogen auf das Gewicht des Copolymeren i), vorliegt.

**17.** Verwendung von strahlungsempfindlichen Zusammensetzungen nach Anspruch 8 zur Herstellung von Schutzschichten und Reliefstrukturen, insbesondere zur Herstellung von Druckplatten, gedruckten Schaltungen und integrierten Schaltkreisen.

Europäisches Patentamt

# EUROPÄISCHER RECHERCHENBERICHT

Nummer der Anmeldung

EP 92 81 0125

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 063 975 (J.G.ABRAMO)<br>--- | | C08F212/14<br>G03F7/038 |
| A | PATENT ABSTRACTS OF JAPAN<br>vol. 11, no. 264 (P-610)(2711) 27. August 1987<br>& JP-A-62 069 262 ( TOSHIBA ) 24. September 1985<br>* Zusammenfassung *<br>--- | | |
| A | PATENT ABSTRACTS OF JAPAN<br>vol. 10, no. 282 (P-500)(2338) 25. September 1986<br>& JP-A-61 100 745 ( DAINIPPON PRINTING CO LTD ) 23. Oktober 1984<br>* Zusammenfassung *<br>----- | | |
| | | | RECHERCHIERTE SACHGEBIETE (Int. Cl.5) |
| | | | C08F<br>G03F |

Der vorliegende Recherchenbericht wurde für alle Patentansprüche erstellt

| Recherchenort | Abschlußdatum der Recherche | Prüfer |
|---|---|---|
| DEN HAAG | 01 JUNI 1992 | CAUWENBERG C.L. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)